**Europäisches Patentamt**

**European Patent Office**

**Office européen des brevets**

(19)

(11) Veröffentlichungsnummer: **0 195 480 B1**

(12) # EUROPÄISCHE PATENTSCHRIFT

(45) Veröffentlichungstag der Patentschrift:
**31.01.90**

(51) Int. Cl.⁴: **H 03 J 5/24**

(21) Anmeldenummer: **86200389.4**

(22) Anmeldetag: **11.03.86**

(54) Schaltungsanordnung für einen Tuner zur Umschaltung zweier Frequenzbänder.

(30) Priorität: **16.03.85 DE 3509517**

(43) Veröffentlichungstag der Anmeldung:
**24.09.86 Patentblatt 86/39**

(45) Bekanntmachung des Hinweises auf die Patenterteilung:
**31.01.90 Patentblatt 90/5**

(84) Benannte Vertragsstaaten:
**DE FR GB**

(56) Entgegenhaltungen:
**DE-A- 1 909 244
DE-A- 2 503 785
DE-A- 2 523 536
FR-A- 2 511 821
US-A- 3 903 487**

(73) Patentinhaber: **Philips Patentverwaltung GmbH,
Wendenstrasse 35 Postfach 10 51 49,
D-2000 Hamburg 1 (DE)**

(84) Benannte Vertragsstaaten: **DE**

(73) Patentinhaber: **N.V. Philips' Gloeilampenfabrieken,
Groenewoudseweg 1, NL-5621 BA Eindhoven (NL)**

(84) Benannte Vertragsstaaten: **FR GB**

(72) Erfinder: **Kupfer, Karl-Heinz, Krefelder Strasse 145,
D-4150 Krefeld 29 (DE)**

(74) Vertreter: **Kupfermann, Fritz-Joachim, Dipl.-Ing. et al,
Philips Patentverwaltung GmbH
Wendenstrasse 35 Postfach 10 51 49,
D-2000 Hamburg 1 (DE)**

**Beschreibung**

Die Erfindung betrifft eine Schaltungsanordnung für einen Tuner, insbesondere Fernsehtuner, zur Umschaltung zweier mittels Bandfilter, die je eine eingangsseitige vorgesehene, der Abstimmung dienende Kapazitätsdiode aufweisen, ausgefilterter Frequenzbänder mit Hilfe von Schaltdioden, wobei nie beide Bandfilter gleichzeitig auf Durchlaß geschaltet sind.

Bei solchen Schaltungsanordnungen ist bekannt, an jedem der Bandfilter jeweils am Ein- und Ausgang eine Abstimmeinheit mit einer Kapazitätsdiode anzuordnen. Die Sekundärseiten der Bandfilter werden dann hinter den Abstimmeinheiten auf je einen Eingang eines Mischers, meistens eines Mischer-ICs geführt. An diesen Eingängen muß eine Schaltmöglichkeit für die Ausgangssignale dieser Bandfilter vorgesehen werden, da nur das Signal eines der Bandfilter in den Mischer gelangen darf. Diese Schaltanordnungen sind meistens mit Schaltdioden ausgeführt, die mittels eines Schaltsignals in den leitenden Zustand versetzt werden, wodurch das Ausgangssignal des Bandfilters gegen Masse kurzgeschlossen wird.

So ist z. B. aus der US-A 4 408 348 eine Abstimmeinheit für drei Frequenzbänder bekannt, die drei abstimmbare Filter für jedes der drei Frequenzbänder aufweist. Jedes der drei Bandfilter weist am Ein- und Ausgang je eine Abstimmeinheit mit je einer Kapazitätsdiode auf.

Die DE-A 1 909 244 offenbart eine Schaltungsanordnung für einen Fernsehempfänger mit einer Abstimm- und Umschalteinrichtung für zwei Fernsehfrequenzbänder im Bereich I und III der Ultrakurzwelle, wobei die Umschaltung der Empfänger-Eingangsfilter durch einen Diodenschalter im Eingang des Eingangsfilters für den Bereich I mit Hilfe einer Schaltspannung erfolgt.

Ferner ist aus der DE-A 2 503 785 ein abstimmbarer Resonanzkreis für wenigstens zwei Frequenzbereiche bekannt, bei dem z. B. für die Frequenzbereiche UHF, VHF I und VHF II ein gemeinsamer abstimmbarer Resonanzkreis vorgesehen ist. In diesem Resonanzkreis ist jedoch das höchste Band, in dem Beispiel also das UHF-Band, ständig auf Durchlaß geschaltet. Dies wiederum hat zur Folge, daß z. B. bei einem Empfang im VHF II-Band in Folge Oberwellenbildung ein Störsignal im UHF-Bereich entsteht, das ebenso wie das Nutzsignal zum Mischer gelangt.

Es ist Aufgabe der Erfindung, eine Schaltungsanordnung zur Umschaltung mehrerer Bandfilter zu schaffen, bei der immer nur ein Frequenzbereich auf Durchlaß geschaltet ist und die bezüglich der Zusammenschaltung der Bandfilter und deren Abstimmung einen einfachen und wirtschaftlichen Aufbau aufweist.

Diese Aufgabe ist erfindungsgemäß dadurch gelöst, daß

– die Signale hinter den Bandfiltern auf eine gemeinsame, sekundärseitige Abstimmeinheit, die eine der Abstimmung dienende Kapazitätsdiode aufweist, zusammengeführt sind, wobei die Zusammenführung hinter den Bandfiltern in der Art vorgenommen wird, daß

– das erste Bandfilter mit Hilfe einer im Fußpunkt des Bandfilters angeordneten Schaltdiode bei leitender Diode das Signal durchläßt und eine kleinere Ausgangsreaktanz aufweist, während das Bandfilter bei gesperrter Schaltdiode das Signal sperrt und eine größere Ausgangsreaktanz aufweist,

– und das zweite Bandfilter bei kleinerer Ausgangsreaktanz des ersten Bandfilters den gewünschten Frequenzbereich ausfiltert und bei größerer Ausgangsreaktanz des ersten Bandfilters verstimmt ist.

Eine solche Schaltungsanordnung kommt mit nur noch einer sekundärseitigen Abstimmeinheit aus. Ferner entfällt durch die im Fußpunkt des ersten Bandfilters angeordnete Schaltdiode und die Bauart der Bandfilter eine Schalteinheit. Da die Ausgangssignale der Bandfilter auf eine gemeinsame sekundärseitige Abstimmeinheit zusammengeführt sind, wird auch nur noch ein Mischereingang benötigt.

Trotz des einfachen Aufbaus kann eine gegenseitige Beeinflussung der Frequenzbereiche nicht erfolgen, da immer nur ein Bandfilter auf Durchlaß geschaltet ist. So werden z. B. bei Betrieb im niederfrequenteren Bandbereich gegebenenfalls Oberwellen sicher ausgefiltert, da das Bandfilter für den höherfrequenten Bandbereich dann gesperrt ist.

Dies wird dadurch erreicht, daß ein Bandfilter umschaltbar gestaltet ist, so daß es entweder auf Durchlaß geschaltet ist und eine kleinere Ausgangsreaktanz aufweist, oder daß es sperrt und eine größere Ausgangsreaktanz aufweist. Das zweite Bandfilter arbeitet bei der größeren Ausgangsreaktanz des ersten Bandfilters in dem gewünschten Frequenzbereich, ist jedoch bei kleinerer Ausgangsreaktanz des ersten Bandfilters verstimmt. Auf diese Weise ist trotz einfacher Umschaltung sichergestellt, daß nie beide Bandfilter zur gleichen Zeit das jeweilige Frequenzband durchlassen.

Die Schaltungsanordnung für einen Tuner ist insbesondere geeignet zur Filterung der Umschaltung der Frequenzbänder VHF- und Hyperband. In dem VHF-Bandfilter kann dazu eine bekannte Anordnung zur Umschaltung der beiden VHF-Bereiche vorgesehen sein. Die Schaltungsanordnung kann aber auch für andere Frequenzbereiche eingesetzt werden.

Nach einer weiteren Ausgestaltung der Erfindung ist vorgesehen, daß

– eine Reihenschaltung einer Schaltdiode und einer Kapazität so zwischen die Kapazität und die Induktivität geschaltet ist, daß die Anode der Schaltdiode mit der Kapazität verbunden ist,

– an die Anode der Schaltdiode über einen Widerstand eine Schaltspannung angelegt ist,

– die Kathode der Schaltdiode über einen Widerstand auf Masse geführt ist und

– zur Kapazität und Schaltdiode ein Widerstand parallel liegt.

Diese Schaltungsanordnung bietet bei sehr geringem Bauteileaufwand die oben beschriebenen Vorteile. Außerdem müssen gegenüber den bestehenden Schaltungskonzepten der Bandfilter nur sehr geringe Änderungen vorgenommen werden, da in die Bandfilter nur wenige zusätzliche Bauteile zu integrieren sind.

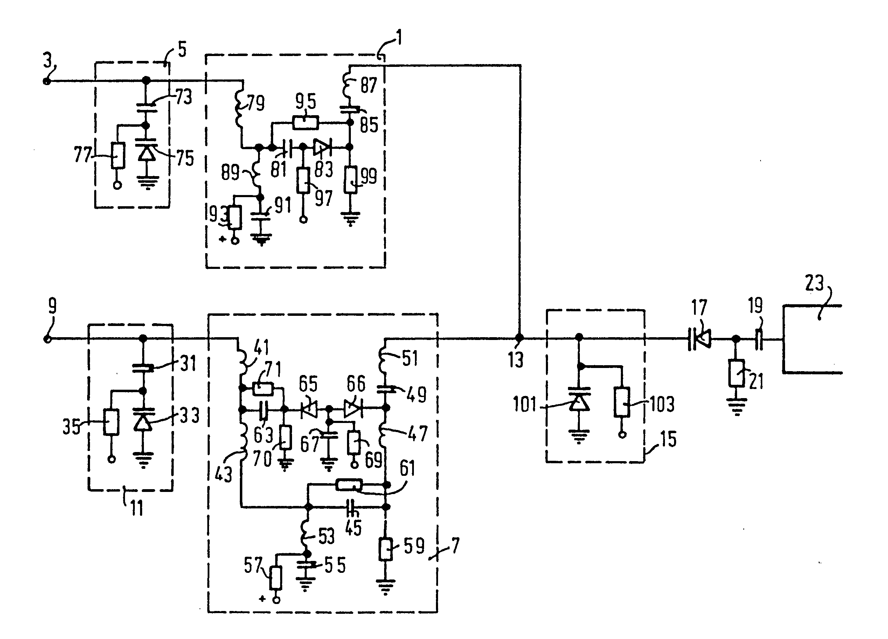

Ein Ausführungsbeispiel der Schaltungsanordnung nach der Erfindung wird anhand der Figur näher erläutert.

Die Figur zeigt oben ein Bandfilter 1 für das Hyperband, an dessen Eingang 3 eine Abstimmeinheit 5 angeordnet ist. Unten ist ein VHF-Bandfilter 7 dargestellt, das an seinem Eingang 9 ebenfalls eine Abstimmeinheit 11 aufweist. Die Ausgänge der beiden Bandfilter 1 und 7 sind auf einen gemeinsamen Sternpunkt 13 zusammengeführt, an dem eine gemeinsame sekundärseitige Abstimmeinheit 15 angeordnet ist. Dieser Sternpunkt 13 führt ferner über eine Kapazitätsdiode 17 und eine Ankoppelkapazität 19, zwischen denen ein Widerstand 21 gegen Masse führt, zu einem Eingang eines Mischers 23, der in der Regel ein Mischer-IC sein wird. Die am Eingang des VHF-Bandfilters 7 angeordnete Abstimmeinheit 11 besteht aus der Reihenschaltung einer Kapazität 31 und einer Kapazitätsdiode 33, die mit ihrer Anode gegen Masse geschaltet ist. Der Kathode der Kapazitätsdiode 33 wird über einen Widerstand 35 die Abstimmspannung zugeführt. Das VHF-Bandfilter 7 ist aus der Reihenschaltung einer ersten Induktivität 41, einer zweiten Induktivität 43, einer Kapazität 45, einer dritten Induktivität 47, einer Kapazität 49 und einer vierten Induktivität 51 aufgebaut. Im Fußpunkt des Bandfilters führt vom Verbindungspunkt der Induktivität 43 und der Kapazität 45 eine Induktivität 53 zum einen über eine Kapazität 55 gegen Masse, zum anderen über einen Widerstand 57 zur Spannungsversorgung. Ferner führt vom Verbindungspunkt der Kapazität 45 und der Induktivität 47 ein Widerstand 59 gegen Masse und ein weiterer Widerstand 61 zum Verbindungspunkt zwischen der Induktivität 43 und der Kapazität 45. Für den Betrieb im Bereich III des VHF-Bandes führt vom Verbindungspunkt der ersten Induktivität 41 und der zweiten Induktivität 43 eine Reihenschaltung einer Kapazität 63 und zweier Schaltdioden 65 und 66 zum Verbindungspunkt zwischen der dritten Induktivität 47 und der Kapazität 49. Die Schaltdioden 65 und 66 sind mit ihren Anoden gegeneinander geschaltet, von denen eine Kapazität 67 gegen Masse und ein Widerstand 69 zu einer Schaltspannung zur Einschaltung des BIII-Bereiches führt. Von der Kathode der Schaltdiode 65 führt ein Widerstand 70 gegen Masse. Parallel zu der Kapazität 63 liegt ein Widerstand 71.

Die primärseitige Abstimmeinheit 5 des Hyperbandfilters 1 ist entsprechend der Abstimmeinheit 11 mit einer Kapazität 73 einer Kapazitätsdiode 75 und einem Widerstand 77 aufgebaut. Das Hyperbandfilter weist eine Reihenschaltung einer Induktivität 79, einer Kapazität 81, einer Schaltdiode 83, einer weiteren Kapazität 85 und einer Induktivität 87 auf, wobei die Schaltdiode mit ihrer Kathode mit der Kapazität 85 verbunden ist. Im Fußpunkt des Bandfilters führt vom Verbindungspunkt der Induktivität 79 und der Kapazität 81 eine Induktivität 89 sowohl über eine Kapazität 91 gegen Masse, wie auch über einen Widerstand 93 zur Spannungsversorgung. Der Kapazität 81 und der Schaltdiode 83 ist ein Widerstand 95 parallelgeschaltet. Der Anode der Schaltdiode 83 wird über einen Widerstand 97 eine Schaltspannung zugeführt. Die Kathode dieser Schaltdiode 83 ist über einen Widerstand 99 mit Masse verbunden.

Die Ausgänge der beiden Bandfilter 1 und 7 führen auf einen gemeinsamen Sternpunkt 13, mit dem die gemeinsame sekundärseitige Abstimmeinheit 15 verbunden ist. In dieser Abstimmeinheit ist eine Kapazitätsdiode 101 mit ihrer Kathode mit dem Sternpunkt 13 mit ihrer Anode mit Masse verbunden. Der Kathode der Kapazitätsdiode 101 wird die Abstimmspannung über einen Widerstand 103 zugeführt.

Der Sternpunkt 13, der den gemeinsamen Ausgang der beiden Bandfilter darstellt, ist, wie oben beschrieben, über eine Kapazitätsdiode 17 und eine Ankoppelkapazität 19 mit dem Eingang eines nachfolgenden Mischers verbunden.

Die Wirkung der Schaltungsanordnung ist folgende:

Bei Hyperbandbetrieb wird der Schaltdiode 83 im Hyperbandfilter 1 über den Widerstand 97 eine positive Spannung zugeführt, so daß die Schaltdiode leitend wird. Es gelangt nun das Hyperbandsignal zum Sternpunkt 13. Die Abstimmung kann vorgenommen werden mit den Abstimmeinheiten 5 und 15. Die Kapazität 85 dient dazu, die über den Widerstand 97 eingekoppelte Schaltgleichspannung abzutrennen. Bei leitender Schaltdiode 83 weist das Hyperbandfilter 1 eine kleinere Ausgangsreaktanz auf, die zu den Induktivitäten 51, 47 und 53 des VHF-Bandfilters 7 parallel liegt und zu einer Verstimmung desselben führt. Voraussetzung hierfür ist, daß das VHF-Bandfilter auf den BI-Bereich des VHF-Bandes geschaltet ist, d.h. es darf den Schaltdioden 65 und 66 keine Schaltspannung über den Widerstand 69 zugeführt werden.

Für Betrieb im VHF-Bereich wird der Schaltdiode 83 keine Schaltspannung über den Widerstand 97 zugeführt, so daß die Schaltdiode 83 sperrt, was durch die der Kathode über den Widerstand 95 zugeführte positive Spannung gewährleistet ist. Das Hyperbandfilter sperrt nun, und es gelangen keine Signale des Hyperbandbereiches zum Sternpunkt 13. Da das Hyperbandfilter 1 in dieser Betriebsart eine deutlich größere Ausgangsreaktanz aufweist und da das VHF-Bandfilter so dimensioniert ist, daß es bei Parallelschaltung dieser größeren Ausgangsreaktanz des Hyperbandfilters 1 auf den gewünschten Bereich abgestimmt ist, arbeitet nun das VHF-Bandfilter, d.h. die VHF-Signale gelangen zum gemeinsamen Sternpunkt 13. Die Abstimmung wird vorgenommen mittels der Abstimmeinheiten 11 und 15.

Um bei Betrieb im Hyperbandbereich, d.h. bei gesperrtem VHF-Bandfilter eine noch bessere Dämpfung der VHF-Signale zu erreichen, kann das an dem Eingang 9 des VHF-Bandfilters 7 anliegende Signal, das im Regelfalle durch einen vorgeschalteten Transistor vorverstärkt wird, durch Wegschalten desselben gesperrt werden.

## Patentansprüche

1. Schaltungsanordnung für einen Tuner, insbesondere Fernsehtuner, zur Umschaltung zweier mittels Bandfilter (1, 7), die je eine eingangsseitige vorgesehene, der Abstimmung dienende Kapazitätsdiode (75, 33) aufweisen, ausgefilterter Frequenzbänder mit Hilfe von Schaltdioden, wobei nie beide Bandfilter gleichzeitig auf Durchlaß geschaltet sind, dadurch gekennzeichnet, daß

— die Signale hinter den Bandfiltern auf eine gemeinsame, sekundärseitige Abstimmeinheit (15), die eine der Abstimmung dienende Kapazitätsdiode (101) aufweist, zusammengeführt sind, wobei die Zusammenführung hinter den Bandfiltern in der Art vorgenommen wird, daß

— das erste Bandfilter (1) mit Hilfe einer im Fußpunkt des Bandfilters (1) angeordneten Schaltdiode (83) bei leitender Diode (83) das Signal durchläßt und eine kleinere Ausgangsreaktanz aufweist, während das Bandfilter (1) bei gesperrter Schaltdiode (83) das Signal sperrt und eine grössere Ausgangsreaktanz aufweist,

— und das zweite Bandfilter (7) bei größerer Ausgangsreaktanz des ersten Bandfilters (1) den gewünschten Frequenzbereich ausfiltert und bei kleinerer Ausgangsreaktanz des ersten Bandfilters (1) verstimmt ist.

2. Schaltungsanordnung nach Anspruch 1, in der das erste Bandfilter (1) aus einer Induktivität (79), einer Kapazität (81) und einer Induktivität (87), die in Reihe geschaltet sind, und einer weiteren Induktivität (89), die einerseits zum Verbindungspunkt zwischen der Induktivität (79) und der Kapazität (81) und andererseits über eine Kapazität (91) gegen Masse und über einen Widerstand (93) und zur Stromversorgung geführt ist, aufgebaut ist, dadurch gekennzeichnet, daß

— eine Reihenschaltung einer Schaltdiode (83) und einer Kapazität (85) so zwischen die Kapazität (81) und die Induktivität (87) geschaltet ist, daß die Anode der Schaltdiode (83) mit der Kapazität (81) verbunden ist,

— an die Anode der Schaltdiode (81) über einen Widerstand (97) eine Schaltspannung angelegt ist,

— die Kathode der Schaltdiode (81) über einen Widerstand (99) auf Masse geführt ist und

— zur Kapazität (81) und Schaltdiode (83) ein Widerstand (95) parallel liegt.

## Claims

1. A circuit arrangement for a tuner, particularly a television tuner, for a change-over switching between two frequency bands with the aid of switching diodes, said frequency bands being filtered out by means of bandpass filters (1, 7) each having capacitance diodes (75, 83) provided at their inputs for the purpose of tuning, said two bandpass filters never being simultaneously forward-biased, characterized in that

— the signals after passing through the bandpass filters are applied to a common tunable circuit (15) on the secondary side provided with a capacitance diode (101) used for tuning, the operation of combining the signals behind the bandpass filters being effected such that

— the first bandpass filter (1) passes the signal through by means of a switching diode (83) arranged at the low end of the bandpass filter (1) when this diode (83) is conducting and has a smaller output reactance, whereas the bandpass filter (1), when said diode (83) is blocking, cuts off the signal and has a larger output reactance,

— and the second bandpass filter (7) filters out the desired frequency range in the case of a larger output reactance of the first bandpass filter (1) and is detuned in the case of a smaller output reactance of the first bandpass filter (1).

2. A circuit arrangement as claimed in claim 1, in which the first bandpass filter (1) comprises a series arrangement of an inductor (79), a capacitor (81) and an inductor (87), and a further inductor (89) connected at one end to the junction between the inductor (79) and the capacitor (81) and at the other end to ground via a capacitor (91) and to the voltage supply via a resistor (93), characterized in that

— a series arrangement of a switching diode (83) and a capacitor (85) is disposed between the capacitor (81) and the inductor (87) in such a way that the anode of the switching diode (83) is connected to the capacitor (81),

— a switching voltage is applied to the anode of the switching diode (81) via a resistor (97),

— the cathode of the switching diode (81) is connected to ground via a resistor (99),

— a resistor (95) is arranged in parallel with the capacitor (81) and the switching diode (83).

## Revendications

1. Montage de circuit pour un bloc d'accord, en particulier un bloc d'accord de télévision, en vue de la commutation à l'aide de diodes commutatrices de deux bandes de fréquence filtrées au moyen de filtres de bande (1, 7) qui présentent chacun une diode à capacité variable prévue du côté d'entrée et servant à l'accord, étant entendu que les deux filtres de bande ne sont jamais amenés simultanément en sens passant, caractérisé en ce que

— les signaux en aval des filtres de bande se rejoignent dans une unité d'accord commune située du côté secondaire (15) qui comporte une diode à capacité variable (101) servant à l'accord, la jonction s'effectuant derrière les filtres de bande d'une manière telle que

— le premier filtre de bande (1), à l'aide d'une diode commutatrice (83) prévue dans la base du filtre de bande (1), laisse passer le signal lorsque la diode (83) est conductrice et présente une réactance de sortie plus faible, tandis que le filtre de bande (1), lorsque la diode commutatrice (83) est bloquée, bloque le signal et présente une réactance de sortie plus forte;

— et le second filtre de bande (7) filtre le domaine de fréquence souhaité en présence d'une réactance de sortie plus forte du premier filtre de bande (1) et est désaccordé en présence d'une réactance de sortie plus faible du premier filtre de bande (1).

2. Montage de circuit suivant la revendication 1, dans lequel le premier filtre de bande (1) est constitué d'une inductance (79), d'une capacité (81) et d'une inductance (87), qui sont connectées en série, ainsi que d'une autre inductance (89), qui est connectée, d'une part au point de jonction entre l'inductance (79) et la capacité (81) et, d'autre part, par l'intermédiaire d'une capacité (91), à la masse et, par l'intermédiaire d'une résistance (93), à l'alimentation de courant, caractérisé en ce que

— un montage en série d'une diode commutatrice (83) et d'une capacité (85) est connecté entre la capacité (81) et l'inductance (87) d'une manière telle que l'anode de la diode commutatrice (83) soit connectée à la capacité (81);

— une tension de commutation est appliquée à l'anode de la diode commutatrice (81) par l'intermédiaire d'une résistance (97);

— la cathode de la diode commutatrice (81) est mise à la masse par l'intermédiaire d'une résistance (99), et

— une résistance (95) est en parallèle avec la capacité (81) et la diode commutatrice (83).